(19) Europäisches Patentamt
European Patent Office
Office européen des brevets

(11) Numéro de publication : **0 169 113 B1**

(12) # FASCICULE DE BREVET EUROPÉEN

(45) Date de publication du fascicule du brevet :
**20.01.88**

(51) Int. Cl.⁴ : **B 60 R 11/02**

(21) Numéro de dépôt : **85401203.6**

(22) Date de dépôt : **18.06.85**

(54) **Dispositif de montage d'un équipement tel que notamment un récepteur radio disposé à l'intérieur de l'habitacle d'un véhicule automobile.**

(30) Priorité : **22.06.84 FR 8409840**

(43) Date de publication de la demande :
**22.01.86 Bulletin 86/04**

(45) Mention de la délivrance du brevet :
**20.01.88 Bulletin 88/03**

(84) Etats contractants désignés :
**DE GB IT SE**

(56) Documents cités :
**DE-A- 2 536 854**
**DE-A- 2 643 579**
**FR-A- 2 550 742**
**US-A- 1 802 345**
**PATENTS ABSTRACTS OF JAPAN, vol. 8, no. 5 (M-267)[1442], 11 janvier 1984; & JP - A - 58 170 646 (NISSAN JIDOSHA K.K.) 07.10.1983**

(73) Titulaire : **REGIE NATIONALE DES USINES RENAULT**
**Boîte postale 103 8-10 avenue Emile Zola**
**F-92109 Boulogne-Billancourt (FR)**

(72) Inventeur : **Bascou, Jacques**
**15, rue de la Fontaine Pleureuse Bazemont**
**F-78580 Maule (FR)**
Inventeur : **Bastin, Jacques**
**3, Alleé Hélène Boucher**
**F-95250 Beauchamp (FR)**
Inventeur : **Lampreia, François**
**25, route de Chasse**
**F-91700 Sainte Genevieve des Bois (FR)**

(74) Mandataire : **Saint Martin, René et al**
**Régie Nationale des Usines Renault Direction des Recherches et Développements Service 0804 8-10, Avenue Emile-Zola**
**F-92109 Boulogne Billancourt Cedex (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet le montage d'un équipement à l'intérieur d'un véhicule automobile. Elle vise plus particulièrement le montage d'un récepteur radio, communément appelé « autoradio », sur une console ou sur la planche de bord du véhicule.

Afin de remédier au problème du vol des autoradios on a déjà proposé de monter ces derniers à l'aide d'un boîtier amovible en forme de tiroir que l'utilisateur retire lorsqu'il quitte le véhicule.

Toutefois, outre qu'il nécessite de transporter l'autoradio en dehors du véhicule, ce dispositif est peu avantageux au regard du style et de l'aspect de l'habitacle lorsque l'autoradio est enlevé, il subsiste alors en effet une ouverture béante dans l'habitacle ainsi parfois qu'un dispositif de connexion peu esthétique.

Afin de remédier aux inconvénients des dispositifs de montage connus la présente invention propose un dispositif de montage d'un équipement tel que notamment un récepteur radio disposé à l'intérieur de l'habitacle d'un véhicule automobile dans une ouverture formée dans l'habillage de ce dernier caractérisé en ce que ledit équipement est disposé dans un boîtier articulé sur une partie fixe de l'habillage pour pivoter depuis une position normale de fonctionnement dans laquelle ledit équipement est accessible à l'utilisateur par ladite ouverture vers une position escamotée dans laquelle l'ouverture est obturée par une partie complémentaire du boîtier, formant couvercle.

Selon une autre caractéristique de l'invention, le dispositif de montage comporte un dispositif d'actionnement disposé entre ladite partie fixe et ledit boîtier pour provoquer le pivotement de ce dernier depuis sa position escamotée vers sa position normale de fonctionnement.

Le dispositif comporte également un dispositif de verrouillage permettant de verrouiller le boîtier en position escamotée.

D'autres caractéristiques et avantages de l'invention apparaîtront plus clairement à la lecture de la description qui va suivre, pour la compréhension de laquelle on se reportera aux dessins annexés dans lesquels :

- la figure 1 est une vue en perspective d'une console de véhicule automobile équipée d'un autoradio monté à l'aide d'un dispositif réalisé conformément aux enseignements de la présente invention et représenté dans sa position normale de fonctionnement.

- la figure 2 est une vue similaire à celle de la figure 1 dans laquelle l'autoradio est dans sa position escamotée et verrouillée ;

- la figure 3 est une vue en coupe latérale de la console de la figure 1 ;

- la figure 4 est une vue de détail suivant la flèche F de la figure 3 ;

- la figure 5 est une vue de dessus du bouton de verrouillage du dispositif ; et

- la figure 6 est une vue en coupe selon la ligne 6-6 de la figure 5.

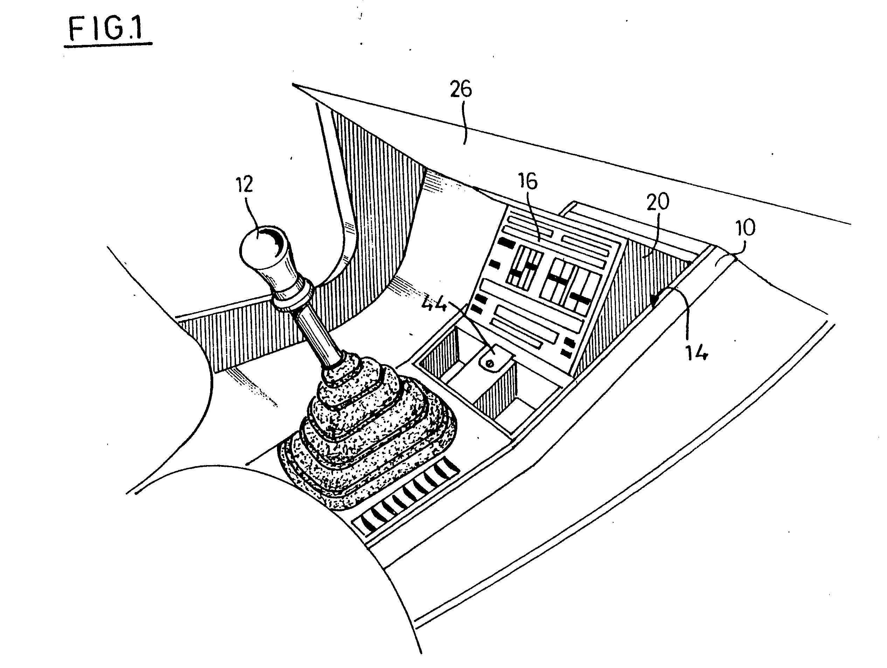

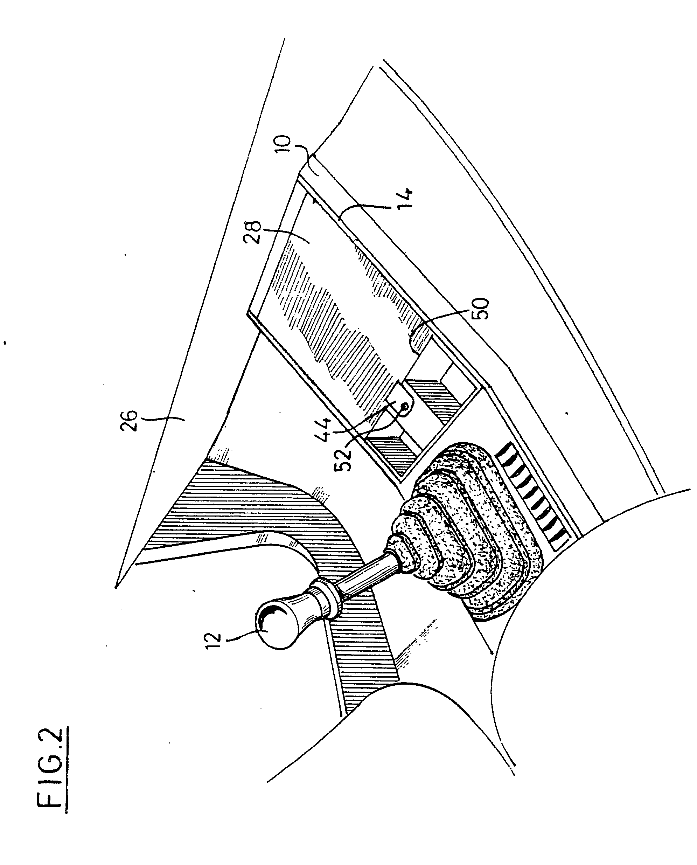

On a représenté aux figures 1 et 2 une partie de l'habitacle d'un véhicule automobile comportant notamment une console 10 sur laquelle est montée le levier de commande 12 du changement de vitesse du véhicule.

La partie fixe de l'habillage de l'habitacle constituée par la console 10 est munie d'une ouverture rectangulaire 14 dans laquelle est disposé un récepteur radio 16 communément appelé autoradio.

L'autoradio 16 est disposé dans un boîtier 18 dont une des faces latérales 20 est apparente à la figure 1.

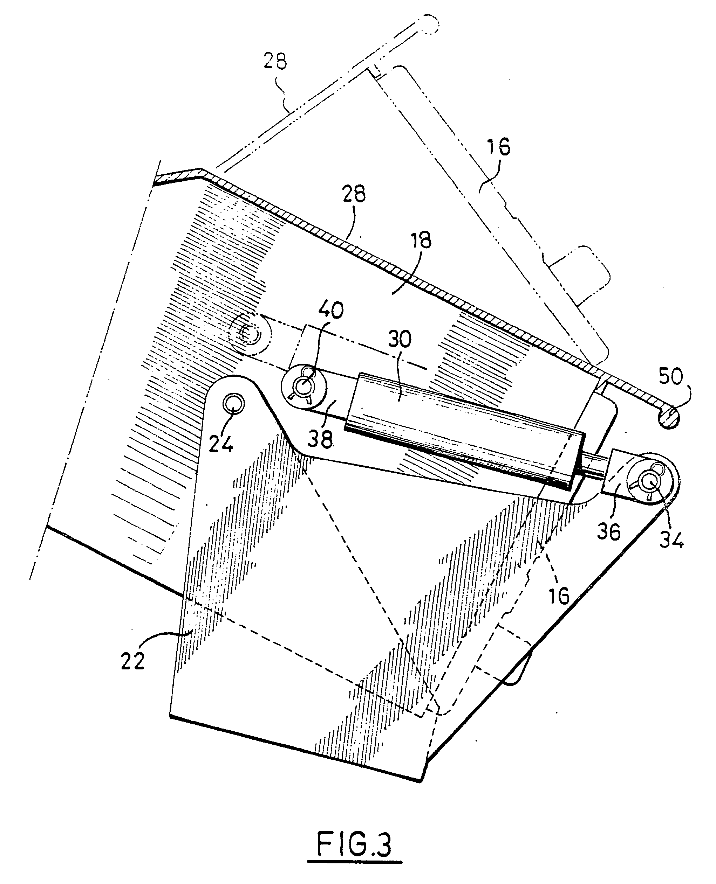

A la figure 3, l'autoradio est représenté en traits forts dans sa position escamotée et en pointillés dans sa position normale de fonctionnement correspondant à la figure 1.

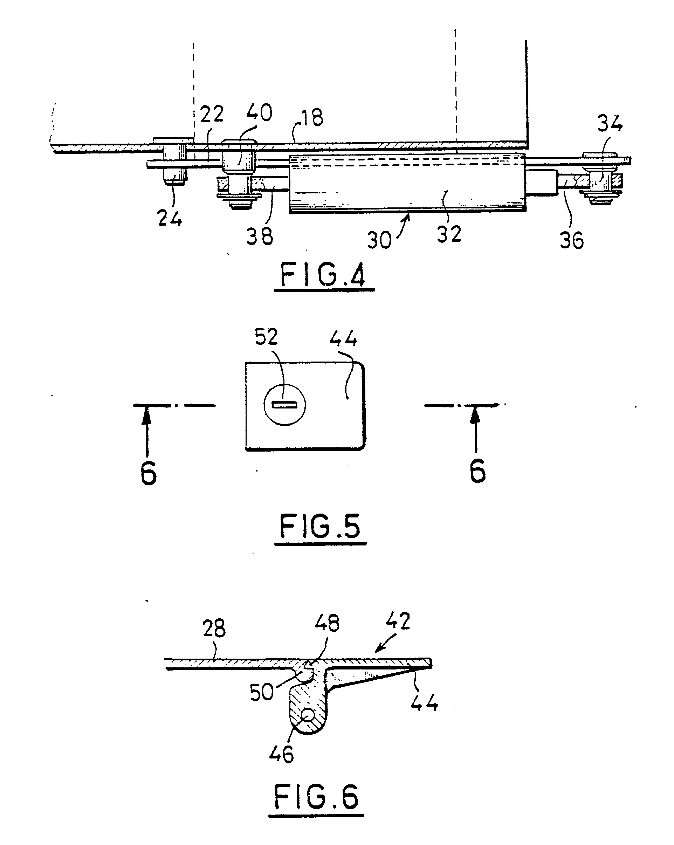

Le boîtier 18 est articulé sur un support fixe symétrique 22 de la console 10 au moyen d'axes d'articulation 24 dont un seul est représenté aux figures 3 et 4.

Comme on peut le constater à la figure 1, le boîtier 18 possède une forme complémentaire de celle de la console 10 et la partie supérieure 26 de l'habillage de l'habitacle de façon à s'intégrer le plus harmonieusement possible à ce dernier lorsque l'autoradio occupe sa position normale de fonctionnement.

Le boîtier 18 est muni à sa face supérieure d'une partie 28 formant couvercle. Lorsque l'autoradio est dans sa position escamotée représentée aux figures 2, 3 et 4, la partie 28 obture complètement l'ouverture 14 de la console de façon à ce que cette dernière présente une face supérieure lisse sur laquelle on ne distingue plus, ni la présence de l'ouverture, ni même l'existence de l'autoradio qui équipe le véhicule.

Afin de provoquer le pivotement automatique du boîtier vers la position normale de fonctionnement et d'utilisation de l'autoradio, celui ci est muni d'un dispositif d'actionnement 30.

Le dispositif d'actionnement 30 est constitué par un vérin 32 travaillant en compression dont une extrémité 34 est articulée sur le support fixe 22 au moyen d'un axe 36 et dont l'autre extrémité 38 est articulée sur le boîtier 18 au moyen d'un axe 40.

Si cela s'avère nécessaire, le dispositif de montage peut être équipé de manière symétrique d'un second vérin d'actionnement.

Afin de maintenir le boîtier dans sa position escamotée, et ce à l'encontre de l'effort exercé par le vérin 32, le dispositif de montage comporte un dispositif de verrouillage en position 42.

Le dispositif de verrouillage 42 est constitué par un bouton basculant 44 articulé sur un axe 46 de la console 10. Un ergot 48 du bouton 44 maintient le bord extrême 50 de la face supérieure 28 du boîtier 18.

Afin d'assurer le verrouillage en position escamotée du boîtier 18 et éviter tout vol de l'autoradio, le bouton basculant 44 peut être muni d'un verrou à barillet 52.

Pour escamoter l'autoradio après utilisation il suffit à l'automobiliste d'appliquer un effort vers le bas sur le bord extrême 50 de la face supérieure 28 du boîtier, à l'encontre de l'effort exercé par le vérin 32 jusqu'à amener le boîtier dans sa position escamotée dans laquelle il sera maintenu en position par le dispositif de verrouillage 42.

## Revendications

1. Dispositif de montage d'un équipement tel que notamment un récepteur radio (16) disposé à l'intérieur de l'habitacle d'un véhicule automobile dans une ouverture 14 formée dans l'habillage (10) de ce dernier caractérisé en ce que ledit équipement (16) est disposé dans un boîtier (18) articulé sur une partie fixe (22) de l'habillage (10) pour pivoter depuis une position normale de fonctionnement dans laquelle ledit équipement est accessible à l'utilisateur par ladite ouverture vers une position escamotée dans laquelle l'ouverture (14) est obturée par une partie (28) complémentaire du boîtier, formant couvercle.

2. Dispositif de montage selon la revendication 1 caractérisé en ce qu'il comporte un dispositif d'actionnement (30) disposé entre ladite partie fixe (22) et ledit boîtier (18) pour provoquer le pivotement de ce dernier depuis sa position escamotée vers sa position normale de fonctionnement.

3. Dispositif de montage selon la revendication 2 caractérisé en ce que ledit dispositif d'actionnement est un vérin (32) travaillant en compression dont une extrémité (36) est articulée sur ladite partie fixe (22) et dont l'autre extrémité (38) est articulée sur le boîtier (18).

4. Dispositif de montage selon l'une des revendications 1 à 3 caractérisé en ce qu'il comporte un dispositif de verrouillage (42) permettant de verrouiller ledit boîtier (18) en position escamotée.

## Claims

1. An arrangement for mounting an item of equipment such as in particular a radio receiver (16) which is disposed in the interior of the passenger compartment of a motor vehicle in an opening (14) formed in the fittings (10) thereof, characterised in that said item of equipment (16) is disposed in a casing (18) which is pivoted on a fixed part (22) of the fittings (10) to pivot from a normal operating position in which said item of equipment is accessible to the user by way of said opening towards a retracted position in which the opening (14) is closed by a complementary part (28) of the casing, forming a cover.

2. An arrangement according to claim 1 characterised in that it comprises an actuating means (30) disposed between said fixed part (22) and said casing (18) to cause pivotal movement of the latter from its retracted position to its normal operating position.

3. An arrangement according to claim 2 characterised in that said actuating means is a jack (32) which operates in compression and of which one end (36) is pivotally connected to said fixed part (22) while the other end (38) is pivotally connected to the casing (18).

4. An arrangement according to one of claims 1 to 3 characterised in that it comprises a locking means (42) for locking said casing (18) in the retracted position.

## Patentansprüche

1. Montagevorrichtung für ein Zubehörteil, insbesondere einen Radioempfänger (16), die im Inneren des Fahrgastraumes eines Kraftfahrzeuges in einer Öffnung (14) angeordnet ist, welche in der Mittelkonsole (10) vorgesehen ist, dadurch gekennzeichnet, daß das Zubehörteil (16) in einem Gehäuse (18) angeordnet ist, das an einem feststehenden Teil (22) der Konsole (10) angelenkt ist, um so aus einer normalen Betriebsstellung, in der das Zubehörteil dem Benutzer durch die Öffnung zugänglich ist, in eine versenkte Stellung verschwenkt zu werden, in der die Öffnung (14) durch ein an das Gehäuse angepaßtes, als Deckel dienendes Teil (28) verschlossen ist.

2. Montagevorrichtung nach Anspruch 1, dadurch gekennzeichnet, daß es eine Betätigungsanordnung (30) aufweist, die zwischen dem feststehenden Teil (22) und dem Gehäuse (18) angeordnet ist, um ein Verschwenken des letzteren aus seiner versenkten Stellung in seine normale Betriebsstellung zu ermöglichen.

3. Montagevorrichtung nach Anspruch 2, dadurch gekennzeichnet, daß die Betätigungsanordnung eine komprimierbare Hebevorrichtung (32) ist, deren eines Ende (36) am feststehenden Teil (22) angelenkt ist und deren anderes Ende (38) am Gehäuse (18) angelenkt ist.

4. Montagevorrichtung nach einem der Ansprüche 1 bis 3, dadurch gekennzeichnet, daß sie eine Verriegelungsanordnung (42) aufweist zur Verriegelung des Gehäuses (18) in der versenkten Stellung.

# FIG.1

0 169 113

# FIG.2

0 169 113

28

16

28

18

40

30

50

24

38

36

34

22

16

## FIG.3

FIG.4

FIG.5

FIG.6